# NOUVEAU FASCICULE DE BREVET EUROPEEN

(11) **EP 3 989 688 B2**
(45) Date de publication et mention de la décision concernant l'opposition: **11.02.2026**
(45) Mention de la délivrance du brevet: 29.03.2023
(21) Numéro de dépôt: 21203391.4
(22) Date de dépôt: 19.10.2021
(51) Int. Cl.: H05K 7/14, B61C 17/00, B61D 17/12, B61C 3/00

(54) **COFFRE DE TOIT, VÉHICULE ÉQUIPÉ D'UN TEL COFFRE ET PROCÉDÉ DE FABRICATION ASSOCIÉ**
DACHBOX, MIT EINER SOLCHEN DACHBOX AUSGESTATTETES FAHRZEUG UND ENTSPRECHENDES HERSTELLUNGSVERFAHREN
BOX FOR ROOF, VEHICLE EQUIPPED WITH SUCH A BOX AND METHOD FOR MANUFACTURING SAME

(30) Priorité: 20.10.2020 FR 2010758
(43) Date de publication de la demande: 27.04.2022
(73) Titulaire: ALSTOM Holdings, 93400 Saint-Ouen-sur-Seine (FR)
(72) Inventeur: BARABAN, Ludovic, 65000 Tarbes (FR); NARBAIS-JAUREGUY, Catherine, 64000 Pau (FR); MORERE, Thomas, 65600 Semeac (FR); MAMY, Marine, 65000 Tarbes (FR); LACOMBE, Laurent, 65690 Barbazan-Debat (FR); DUVERMY, Nicolas, 65310 Horgues (FR); ETCHEVERRY, Bernard, 65000 Tarbes (FR)
(74) Mandataire: Plasseraud IP

(56) Documents cités:
- EP-A1- 3 239 013
- DE-U1- 202015 102 978
- DE-U1- 202017 101 238
- FR-A1- 3 092 555
- ANONYMOUS: "BORDLINE® für Stadt- und Strassenbahnen: Antriebs- und Hilfsbetriebeumrichter und komplette Traktionsspakete", FIRMENSCHRIFT, 3BHS262329ZAB D01,2008-2009, ABB SCHWEIZ AG, 1 January 2008 (2008-01-01), pages 1 - 5, XP093148963, Retrieved from the Internet <URL:https://library.e.abb.com/public/3c5c09951789451b992af4a5515cfad1/ABB_Traction_Converters_LRV_V4d_d_WEB-PDF.pdf> [retrieved on 20240408]
- ANONYMOUS: "Propulsion and auxiliary converter for diesel-electric rail vehicles KONTRAC GP550DE", KONČAR - ELECTRONICS AND INFORMATICS, KONČAR - ELECTRONICS AND INFORMATICS INC. SHORT: KONČAR - INEM INC., 21 October 2019 (2019-10-21), pages 1 - 2, XP093148947, Retrieved from the Internet <URL:https://web.archive.org/web/20191021010029/http://www.koncar-inem.hr:80/en/products/transportation/converters-for-trains/propulsion-and-auxiliary-converter-for-diesel-electric-rail-vehicles-kontrac-gp-550-de/> [retrieved on 20240408]
- ANONYMOUS: "Schweißen", WIKIPEDIA, 11 May 2020 (2020-05-11), pages 1 - 23, XP093148960, Retrieved from the Internet <URL:https://de.wikipedia.org/w/index.php?title=Schweißen&oldid=199855587> [retrieved on 20240408]

## Description

La présente invention concerne un coffre de toit pour un véhicule de transport en commun. La présente invention concerne également un véhicule équipé d'un tel coffre et un procédé de fabrication d'un tel coffre de toit.

Des coffres de toit sont employés dans de nombreuses applications pour protéger des équipements disposés sur des toits de véhicules tels que des bus, des trains, ou encore des tramways. Les équipements ainsi protégés incluent par exemple des équipements de régulation ou de transformation électrique prévus notamment pour recevoir d'un pantographe un courant électrique fourni par une caténaire, ou encore des ensembles de piles à combustibles ou des organes de régulation thermique tels que des climatiseurs.

Des coffres de toit sont divulgués dans les documents EP 3 239 013 A1 et FR 3 092 555.

Ces coffres comprennent généralement des tôles rivetées sur une charpente qui sert de support à chacune des tôles. Ces tôles forment alors une enveloppe séparant l'intérieur du coffre de l'extérieur et jouant donc un rôle de protection des équipements contenus dans le coffre, et participant à la rigidité mécanique de la charpente sous-jacente. Afin d'assurer une bonne isolation vis-à-vis de l'eau, les différentes tôles sont en général mastiquées les unes aux autres, c'est-à-dire qu'un mastic est inséré entre des tôles voisines.

Cependant, les coffres de l'état de la technique ne sont pas optimisés. En particulier, les tôles voisines présentent en général un recouvrement important afin d'améliorer l'efficacité et la tenue dans le temps du mastic inséré entre elles. Il en résulte qu'une quantité non négligeable de métal est utilisée dans des portions superposées les unes aux autres pour générer ce recouvrement, ce qui augmente le poids et le coût du coffre de par la présence de ce métal redondant.

Par ailleurs, il arrive fréquemment que les infiltrations apparaissent à travers le mastic, ces infiltrations pouvant déboucher sur une corrosion des tôles et/ou de la charpente, voire dans certains cas sur un endommagement des équipements reçus dans le coffre.

Il existe donc un besoin pour un coffre de toit pour un véhicule de transport en commun qui présente une durabilité augmentée.

A cet effet, il est proposé un coffre de toit pour un véhicule de transport en commun selon la revendication 1.

Selon des modes de réalisation particuliers, le coffre présente une ou plusieurs des caractéristiques suivantes prise(s) isolément ou selon toutes les combinaisons techniquement possibles :
- les tôles sont soudées les unes aux autres de manière à former un ensemble monobloc de tôles.
- chaque portion rectiligne est venue de matière avec l'une des tôles, la portion rectiligne étant notamment formée par pliage de ladite tôle.
- chaque tôle est réalisée en aluminium.
- les tôles sont soudées les unes aux autres par soudure bout à bout.

Il est également proposé un véhicule de transport en commun comportant un coffre tel que précédemment défini.

Selon un mode de réalisation, le véhicule est un véhicule électrique comportant un moteur et un pantographe, le moteur étant configuré pour propulser le véhicule, le pantographe étant configuré pour recevoir un premier courant électrique d'un caténaire et pour transmettre le premier courant à au moins un dispositif accueilli dans le volume interne du coffre, le dispositif étant configuré pour convertir le premier courant en un deuxième courant électrique différent du premier courant électrique et pour alimenter le moteur avec le deuxième courant.

Il est également proposé un procédé de fabrication d'un coffre de toit pour un véhicule de transport en commun selon la revendication 6.

Selon des modes de mise en oeuvre particuliers, le procédé présente une ou plusieurs des caractéristiques suivantes prise(s) isolément ou selon toutes les combinaisons techniquement possibles :
- la première étape d'assemblage comporte l'assemblage de chaque tôle à la charpente avec un premier ensemble de rivets, chaque rivet fixant une tôle à la charpente, le procédé comportant, en outre, une deuxième étape de rivetage comportant le rivetage d'au moins une tôle à la charpente avec un deuxième ensemble de rivets, le deuxième ensemble étant disjoint du premier ensemble, la deuxième étape de rivetage étant mise en oeuvre postérieurement à l'étape de soudage.
- un seuil de distance est défini pour l'enveloppe, chaque rivet du deuxième ensemble étant disposé à une distance inférieure audit seuil d'une soudure entre deux tôles, aucun rivet du premier ensemble n'étant disposé à une distance inférieure audit seuil d'une soudure entre deux tôles, le seuil de distance étant, notamment, égal à 200 millimètres.

Des caractéristiques et avantages de l'invention apparaîtront à la lecture de la description qui va suivre, donnée uniquement à titre d'exemple non limitatif et faite en référence aux dessins annexés, sur lesquels :
[Fig 1] la figure 1 est une représentation schématique d'un exemple de véhicule comportant un coffre selon l'invention,
[Fig 2] [Fig 3] [Fig 4] les figures 2 à 4 sont différentes vues en perspective du coffre de la figure 1,
[Fig 5] la figure 5 est une vue en perspective d'un détail du coffre des figures 2 à 4, et
[Fig 6] la figure 6 est un ordinogramme des étapes d'un procédé de fabrication du coffre de la figure 1.

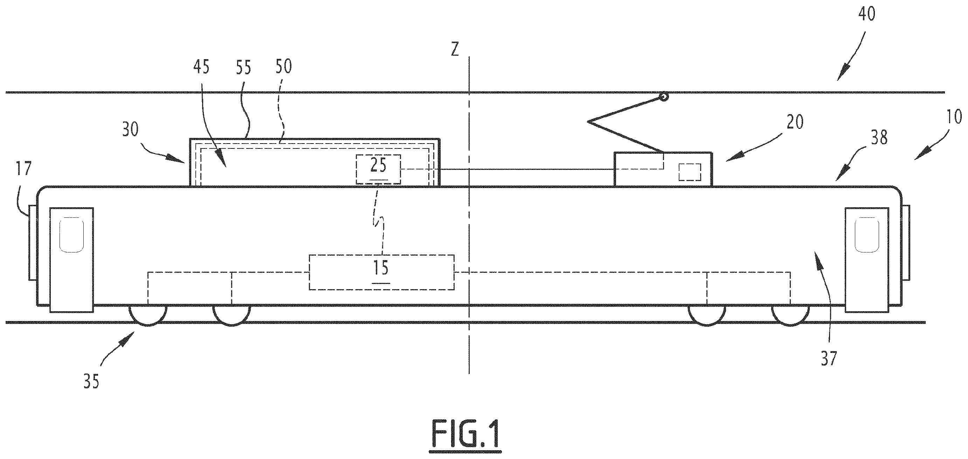

Un exemple de véhicule 10 de transport en commun est représenté sur la figure 1.

Le véhicule 10 est, par exemple, un train, un tramway, un métro ou encore un bus. Toutefois d'autres types de véhicules électriques 10 sont également envisageables

Le véhicule 10 est, par exemple, un véhicule électrique, c'est-à-dire un véhicule prévu pour être propulsé par un moteur électrique 15. Toutefois, d'autres modes de propulsion sont susceptibles d'être envisagés.

Le véhicule 10 comporte, par exemple, outre le moteur électrique 15, une carrosserie 17, un pantographe 20, au moins un dispositif 25 et un coffre de toit 30 accueillant ledit équipement.

Le moteur électrique 15 est configuré pour entraîner les roues 35 du véhicule 10 lorsque le moteur 15 est alimenté avec un premier courant électrique.

La carrosserie 17 délimite au moins un compartiment 37 du véhicule 10. La carrosserie 17 est configurée pour séparer chaque compartiment 37 de l'extérieur du véhicule 10.

La carrosserie 17 comporte, notamment, un toit 38. Le toit 38 délimite chaque compartiment 37 selon une direction verticale Z lorsque le véhicule 10 est en fonctionnement.

Il est en outre défini une direction longitudinale DL pour la carrosserie 17. La direction longitudinale DL est perpendiculaire à la direction verticale Z.

La carrosserie 17 s'étend selon la direction longitudinale DL.

Le pantographe 20 est configuré pour venir en contact d'au moins une caténaire 40 lorsque le véhicule 10 est en mouvement, et pour recevoir de la ou les caténaires 40 un deuxième courant électrique.

Le pantographe 20 est, en outre, configuré pour transmettre le deuxième courant électrique au dispositif 25.

Le dispositif 25 est configuré pour convertir le deuxième courant en le premier courant, et pour transmettre le premier courant au moteur électrique 15. Par exemple, le dispositif 25 est configuré pour générer le premier courant à partir du deuxième courant, le premier courant présentant une tension électrique différente d'une tension électrique du deuxième courant et/ou pour convertir un deuxième courant alternatif ou continu en un premier courant alternatif ou continu de valeur différente, ou encore pour convertir un deuxième courant alternatif présentant une fréquence en un premier courant alternatif présentant une fréquence différente de la fréquence du deuxième courant.

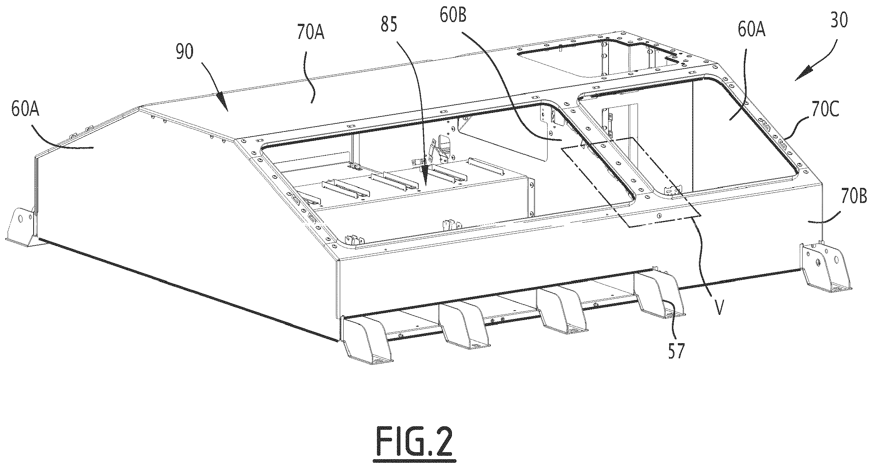

Un exemple de coffre 30 est représenté sous plusieurs orientations différentes sur les figures 2 à 4.

Le coffre 30 est fixé au toit 38. Par exemple, le coffre est supporté par le toit 38. En particulier, le coffre 30 est disposé au-dessus du toit 38 lorsque le véhicule 10 est en fonctionnement.

Le coffre 30 est, par exemple, vissé au toit 38.

Le coffre 30 est configuré pour délimiter un volume interne 45 du coffre 30, et pour séparer le volume interne 45 de l'extérieur du coffre 30.

Il est, notamment, défini une direction principale X pour le coffre 30.

La direction principale X est, par exemple, perpendiculaire à la direction verticale Z du véhicule 10. En particulier, la direction principale X est parallèle à la direction longitudinale DL de la carrosserie 17.

Le coffre s'étend selon la direction principale X.

Il est, en outre, défini une direction secondaire Y, perpendiculaire à la direction principale X et à la direction verticale Z.

Le coffre 30 comporte une charpente 50 et une enveloppe 55. En complément facultatif, le coffre 30 comporte un ensemble de pieds 57. Le coffre 30 comporte au moins un panneau 75, par exemple une pluralité de panneaux 75, et/ou au moins une collerette 80, notamment une collerette 80 pour chaque panneau 75.

Chaque pied 57 est configuré pour être fixé au toit 38, par exemple de manière réversible, et est solidaire de la charpente 50. Chaque pied 57 est, par exemple, configuré pour être vissé au toit 38.

La charpente 50 est configurée pour supporter l'enveloppe 55.

En particulier, la charpente 50 est configurée pour maintenir l'enveloppe 55 en position par rapport à la carrosserie 17.

La charpente 50 est réalisée en un matériau métallique. Par exemple, la charpente 50 est réalisée en acier ou en aluminium, par exemple en un acier revêtu, ou encore en acier inoxydable.

La charpente 50 comporte, par exemple, un ensemble de cloisons 60A, 60B et un ensemble de poutres 65.

En complément facultatif, la charpente 50 est, en outre, configurée pour supporter chaque dispositif 25 contenu dans le volume interne 45. Par exemple, la charpente 50 comporte un plancher, au moins un dispositif 25 étant supporté par le plancher. En variante ou en complément, au moins un dispositif 25 est fixé à au moins une des poutres 65 et/ou à au moins une des cloisons 60A, 60B.

Toutefois, il est à noter que la structure de la charpente 50, notamment le nombre, la forme et la disposition des cloisons 60A, 60B et des poutres 65, est susceptible de varier.

Chaque cloison 60A, 60B est, par exemple, verticale. En particulier, chaque cloison 60A, 60B est perpendiculaire à la direction principale X ou à la direction secondaire Y.

Par exemple, l'ensemble de cloisons 60A, 60B comporte deux cloisons d'extrémité 60A. En particulier, l'ensemble de cloisons 60A, 60B comporte une ou plusieurs cloison(s) intermédiaire(s) 60B.

Les cloisons d'extrémité 60A délimitent, en particulier, le volume interne 45 du coffret 30 selon la direction principale X ou selon la direction secondaire Y.

La cloison intermédiaire 60B divise le volume interne 45 en deux compartiments décalés l'un par rapport à l'autre selon la direction principale X. En particulier, la cloison intermédiaire 60B est interposée entre les deux compartiments selon la direction principale X ou la direction secondaire Y.

Selon un mode de réalisation, chaque cloison 60A, 60B présente un pourtour polygonal. En d'autres termes, chaque cloison 60A, 60B est délimitée dans un plan perpendiculaire à la direction principale X par un contour fermé polygonal. Toutefois, de nombreuses formes de cloisons 60A, 60B sont envisageables.

Selon l'exemple de coffre 30 représenté sur les figures 2 à 5, chaque cloison 60A, 60B est en forme d'hexagone non régulier. En variante, chaque cloison 60A, 60B est rectangulaire, carrée, ou encore triangulaire.

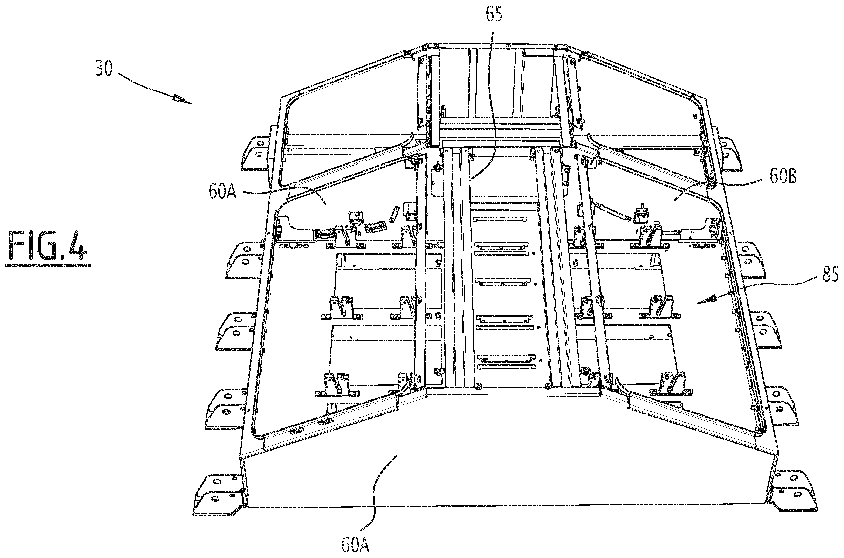

Les poutres 65 sont notamment visibles sur la figure 4. Sur cette figure, l'enveloppe 55 n'est représentée que partiellement pour laisser apparaître les poutres 65.

Chaque poutre 65 s'étend selon la direction principale X ou la direction secondaire Y.

En particulier, chaque poutre 65 est fixée à au moins deux cloisons 60A, 60B, par exemple par rivetage, vissage, ou encore soudage.

Chaque poutre 65 est configurée pour maintenir en position les unes par rapport aux autres les cloisons 60A, 60B auxquelles la poutre 65 est fixée.

L'enveloppe 55 est configurée pour délimiter le volume interne 45 du coffre 30. En particulier, l'enveloppe 55 est configurée pour séparer le volume interne 45 de l'extérieur du coffre 30.

Par exemple, l'enveloppe 50 délimite le volume interne 45 au moins dans un plan perpendiculaire à la direction principale X. Le volume interne 45 est, notamment, entouré au moins partiellement par l'enveloppe 50 dans ce plan.

En particulier, l'enveloppe 55 est configurée pour empêcher le passage d'un objet ou d'une partie du corps d'un opérateur depuis l'extérieur du coffre 30 jusqu'au volume interne 45.

L'enveloppe 55 est, en outre, configurée pour empêcher l'entrée d'eau dans le volume interne 45 depuis l'extérieur du coffre 30.

L'enveloppe 55 est, par exemple, configurée pour assurer un indice de protection de type IP55 ou supérieur.

L'enveloppe 55 comporte un ensemble de tôles 70A, 70B, 70C.

L'enveloppe 55 délimite, pour chaque panneau 75, un passage 85 traversant l'enveloppe 55, le panneau 75 étant configuré pour obturer le passage 85.

L'enveloppe 55 présente une face interne et une face externe 90.

La face interne est dirigée vers le volume interne 45. La face externe 90 est dirigée vers l'extérieur du coffre 30.

Il est notamment entendu par « tôle » une pièce s'étendant sensiblement dans un plan et présentant une épaisseur, mesurée selon une direction perpendiculaire à ce plan, inférieure ou égale à un dixième de chaque dimension de la pièce considérée mesurée selon une direction comprise dans ce plan, notamment inférieure ou égale à un trentième de chaque dimension de la pièce considérée mesurée selon une direction comprise dans ce plan.

Il est également entendu par « tôle » une pièce fabriquée par déformation d'une pièce telle que définie ci-dessus, par exemple par pliage, découpage ou emboutissage.

Chaque tôle 70A, 70B, 70C présente une épaisseur comprise entre 0,8 millimètres (mm) et 10 mm.

Chaque tôle 70A, 70B, 70C présente une face externe et une face interne.

La face externe de chaque tôle 70A, 70B, 70C forme une portion de la face externe 90 de l'enveloppe 55.

La face interne de chaque tôle 70A, 70B, 70C forme une portion de la face interne de l'enveloppe.

Chaque tôle 70 est réalisée en un matériau métallique. Par exemple, chaque tôle 70A, 70B, 70C est réalisée en aluminium. Toutefois, d'autres matériaux sont également envisageables.

Chaque tôle 70A, 70B, 70C est supportée par la charpente 50. Par exemple, chaque tôle 70A, 70B, 70C est supportée par au moins une cloison 60A, 60B et/ou par au moins une poutre 65, chaque cloison 60a, 60B et/ou chaque poutre 65 supportant la tôle 70A, 70B, 70C considérée étant interposée entre le toit 38 et la tôle 70A, 70B, 70C considérée selon la direction verticale Z.

Chaque tôle 70A, 70B, 70C est assemblée à la charpente 50. En particulier, chaque tôle 70A, 70B, 70C est assemblée à chaque cloison 60A, 60B et/ou à chaque poutre 65 supportant la tôle 70A, 70B, 70C. Il est notamment entendu par « assemblée » une fixation mécanique de la tôle 70A, 70B, 70C à la charpente 50, par rivetage, vissage ou toute autre méthode.

Chaque tôle 70A, 70B, 70C est, en outre, soudée à au moins une autre tôle 70A, 70B, 70C.

Il est entendu par « soudé » que chaque tôle 70A, 70B, 70C est fixée à une autre tôle 70A, 70B, 70C de manière à créer une continuité de matière entre les deux tôles 70 considérées, notamment par fusion du matériau composant une des tôles 70A, 70B, 70C ou les deux tôles 70A, 70B, 70C ou par fusion d'un matériau interposé entre les deux tôles 70A, 70B, 70C.

En particulier, les tôles 70A, 70B, 70C sont soudées les unes aux autres de manière à former un ensemble de tôles 70A, 70B, 70C monobloc. En d'autres termes, les tôles 70A, 70B, 70C sont soudées entre elles de manière à ce que chaque tôle 70A, 70B, 70C est mécaniquement solidaire de chaque autre tôle 70A, 70B, 70C. Par exemple, pour chaque paire de tôles 70A, 70B, 70C de l'enveloppe 55, chaque tôle 70A, 70B, 70C de la paire est soit soudée à l'autre tôle 70A, 70B, 70C de la paire soit fixée à l'autre tôle par l'intermédiaire d'une ou plusieurs autres tôles 70A, 70B, 70C.

Les tôles 70A, 70B, 70C sont notamment soudées les unes aux autres par une soudure bout à bout. En particulier, les tôles 70A, 70B, 70C sont soudées les unes aux autres par une soudure bout à bout pleine pénétration.

Il est entendu notamment par « soudure bout à bout » que chaque tôle 70A, 70B, 70C présente une tranche, les tranches de deux tôles 70A, 70B, 70C étant mises en appui l'une contre l'autre et soudées l'une à l'autre de manière à ce que les tôles 70A, 70B, 70C considérées soient soudées l'une à l'autre. En particulier, les tôles 70A, 70B, 70C sont disposées de telle manière que l'enveloppe 55 est dépourvue de portion dans laquelle une face interne d'une tôle 70A, 70B, 70C est en appui contre une face externe d'une autre tôle 70A, 70B, 70C.

La soudure est dite « bout à bout pleine pénétration » lorsque la fusion se produit sur toute l'épaisseur des deux tôles 70A, 70B, 70C.

Les tôles 70A, 70B, 70C sont, notamment, soudées les unes aux autres avec ou sans apport de matière. En d'autres termes, la soudure est soit obtenue par la fusion du matériau métallique composant l'une des tôles 70A, 70B, 70C ou les deux tôles 70A, 70B, 70C qui sont soudées l'une à l'autre, soit par fusion d'un métal d'apport.

Il est à noter que d'autres types de soudures que la soudure bout à bout pleine pénétration sont envisageables.

Comme représenté sur la figure 2, l'ensemble de tôles 70A, 70B, 70C comporte, par exemple, une tôle 70A sommitale, deux tôles 70B latérales et six tôles 70C intermédiaires.

La tôle sommitale 70A est fixée à chaque cloison 60A, 60B.

La tôle sommitale 70A est, par exemple, formée par trois portions non coplanaires venues de matière les unes avec les autres. Une portion de la tôle sommitale 70A est par exemple perpendiculaire à la direction verticale Z et interposée selon la direction secondaire Y entre les deux autres portions, qui présentent un angle non droit avec la direction verticale Z. Toutefois, la forme de la tôle sommitale 70A est susceptible de varier.

La tôle sommitale 70A délimite le volume interne 45 selon la direction verticale Z.

La tôle sommitale 70A n'est pas représentée sur la figure 4 afin de permettre la représentation des poutres 65.

Le volume interne 45 est délimité selon la direction secondaire Y par les tôles latérales 70B.

Chaque tôle latérale 70B est fixée à chaque cloison 60A, 60B.

Chaque tôle intermédiaire 70C s'étend entre la tôle sommitale 70a et l'une des tôles latérales 70B. En particulier, les tôles intermédiaires 70C sont réparties en deux groupes de trois tôles intermédiaires 70C, la tôle sommitale 70A étant interposée selon la direction secondaire Y entre les deux groupes de tôles intermédiaires 70C.

Chaque tôle intermédiaire 70C est, notamment, soudée conjointement à la tôle sommitale 70A et à l'une des tôles latérales 70B.

Chaque passage 85 traverse l'enveloppe 55 depuis l'extérieur de l'enveloppe 55 jusqu'au volume interne 45. Chaque passage 85 traverse l'enveloppe 55 selon une direction normale à l'enveloppe 55.

Il est notamment entendu par « direction normale » une direction perpendiculaire à la face externe 90 de l'enveloppe 55. En particulier, la direction normale est perpendiculaire à chaque tôle 70 délimitant le passage 85.

Chaque passage 85 est, notamment, délimité dans par au moins une tôle 70A, 70B, 70C, par exemple par plusieurs tôles 70A, 70B, 70C soudées les unes aux autres. En particulier, au moins un passage 85 est, par exemple, délimité par plusieurs tôles 70A, 70B, 70C s'étendant dans un même plan. La direction normale du passage 85 est alors une direction perpendiculaire au plan dans lequel les tôles 70A, 70B, 70C délimitant le passage 85 s'étendent.

Selon une variante envisageable, au moins un passage 85 est délimité par des tôles 70A, 70B, 70C non coplanaires les unes aux autres, ou par une tôle 70A, 70B, 70C non plane.

Au moins un passage 85 est, par exemple, délimité par deux tôles intermédiaires 70C, par la tôle sommitale 70A et par l'une des tôles latérales 70B.

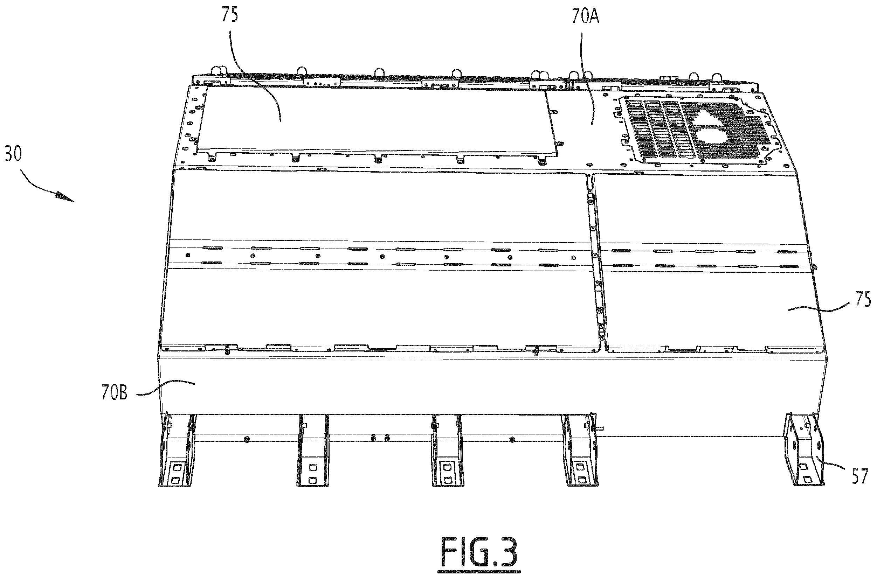

Les panneaux 75 sont notamment représentés sur la figure 3, mais ne sont pas représentés sur les autres figures pour plus de clarté.

Chaque panneau 75 est configuré pour obturer au moins partiellement un passage 85 correspondant de manière amovible. Par exemple, chaque panneau 75 est configuré pour être vissé à l'enveloppe 55. Toutefois, d'autres types de fixations du panneau 75 à l'enveloppe 55 sont envisageables.

Chaque panneau 75 est en regard de la face externe 90 de l'enveloppe 55 lorsque le panneau 75 obture le passage 85 correspondant.

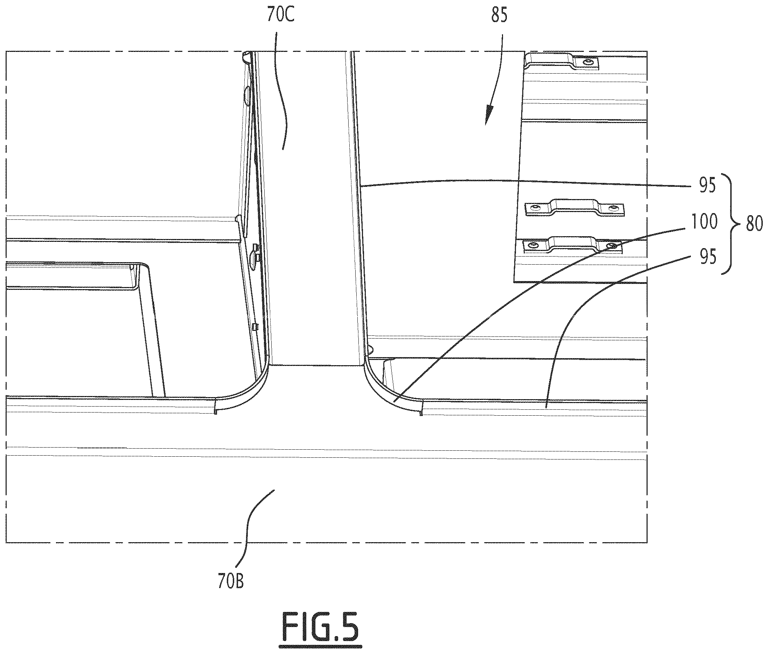

Deux collerettes 80 sont représentées partiellement sur la figure 5.

Chaque collerette 80 entoure un passage 85 correspondant. Chaque collerette 80 entoure le passage 85 correspondant dans un plan perpendiculaire à la direction normale associée au passage 85, lorsqu'une telle direction est définie.

Chaque collerette 80 s'étend vers l'extérieur de l'enveloppe 55 à partir de la face externe 90 de l'enveloppe 55. Chaque collerette 80 s'étend selon la direction normale associée au passage 85 à partir de la face externe 90.

Chaque collerette 80 présente une longueur mesurée à partir de la face externe 90 de l'enveloppe 55. La longueur est comprise, par exemple, entre 100 mm et 3 mètres (m).

En particulier, chaque collerette 80 est interposée entre la face externe 90 et le panneau 75 obturant le passage 85 correspondant à la collerette 80. Un joint (non représenté) est porté par la collerette 80, le panneau 75 étant en appui contre le joint. Le joint est alors interposé entre le panneau 75 et la collerette 80 correspondante.

Chaque joint est, par exemple, un joint en élastomère.

Chaque collerette 80 comporte un ensemble de portions rectilignes 95 et un ensemble de portions courbes 100. Par exemple, chaque collerette 80 comporte quatre portions rectilignes 95 et quatre portions courbes 100 lorsque le passage 85 correspondant à la collerette 80 est sensiblement rectangulaire.

Les portions courbes 100 et les portions rectilignes 95 sont alternées le long de la collerette 80. Ainsi, chaque portion courbe 100 est interposée entre deux portions rectilignes 95 et chaque portion rectiligne 95 est interposée entre deux portions courbes 95.

Chaque portion courbe 100 est, notamment, soudée aux deux portions rectilignes 95 entre lesquelles la portion courbe 100 est interposée.

Chaque portion rectiligne 95 est, par exemple, venue de matière avec une tôle 70A, 70B, 70C délimitant le passage 85. Par exemple, la portion rectiligne 95 est formée par pliage de ladite tôle 70A, 70B, 70C.

Chaque portion rectiligne 95 est, par exemple, parallélépipédique.

Chaque portion courbe 100 est formée par une pièce rapportée soudée à au moins une des tôles 70A, 70B, 70C. Cela signifie notamment que chaque portion courbe 100 n'est pas venue de matière avec l'enveloppe 55.

La pièce formant chaque portion courbe 100 est, par exemple, soudée à au moins une tôle 70A, 70B, 70C, par exemple à une unique tôle 70A, 70B, 70C, par une soudure pleine pénétration ou soudure d'angle.

La pièce formant chaque portion courbe 100 est, en particulier, soudée à la face externe 90 de l'enveloppe 55.

Chaque portion courbe 100 s'étend selon une ligne propre. La ligne propre est, notamment, un arc de cercle. Par exemple, la ligne propre est un quart de cercle lorsque la collerette 80 comporte quatre portions courbes 100.

Chaque portion courbe 100 est, par exemple, en forme de portion d'un cylindre annulaire.

Un cylindre annulaire est délimité par deux cylindres à base circulaire coaxiaux. Dans le cas d'une portion courbe 100, l'axe de chaque cylindre est notamment perpendiculaire à la surface externe 90 de l'enveloppe 55 en un point de contact entre la portion courbe 100 et la surface externe 90.

Une portion de cylindre annulaire est notamment délimitée par deux plans dont l'intersection est l'axe commun aux deux cylindres, ou dont l'intersection est parallèle à cet axe.

Lorsque la ligne propre est un quart de cercle, les deux plans sont perpendiculaires l'un à l'autre.

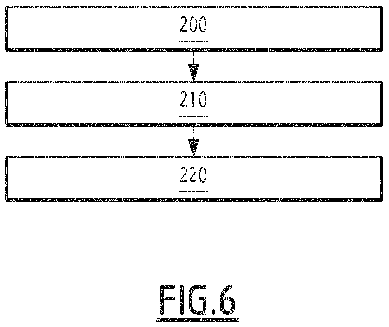

Un procédé de fabrication du coffre 30 va maintenant être décrit en référence à la figure 6, qui est un ordinogramme des étapes du procédé de fabrication.

Le procédé de fabrication comporte une première étape 200 d'assemblage, une étape 210 de soudage et une deuxième étape 220 de rivetage.

Lors de la première étape d'assemblage 200, la charpente 50 est fournie. Par exemple, la charpente 50 est assemblée par fixation des cloisons 60A, 60B et des poutres 65 les unes aux autres.

En outre, lors de la première étape d'assemblage 200, chaque tôle 70A, 70B, 70C est assemblée, notamment rivetée, à la charpente 50.

En particulier, lors de la première étape d'assemblage 200, les tôles 70A, 70B, 70C sont rivetées à la charpente 50 avec un premier ensemble de rivets.

Chaque rivet du premier ensemble est un rivet fixant une tôle 70A, 70B, 70C à la charpente 50.

Un seuil de distance est défini. Le seuil de distance est, par exemple, égal à 200 millimètres. Toutefois, le seuil de distance est susceptible de varier.

L'étape de soudage 210 est mise en oeuvre postérieurement à la première étape d'assemblage 200.

Lors de l'étape de soudage 210, les tôles 70A, 70B, 70C sont soudées entre elles pour former l'enveloppe 55.

En particulier, une pluralité de soudures sont formées, chaque soudure étant une soudure entre deux des tôles 70A, 70B, 70C.

Chaque rivet du premier ensemble est disposé à une distance supérieure ou égale au seuil de distance de chaque soudure de l'enveloppe.

Par exemple, le premier ensemble de rivets comporte, pour chaque tôle 70A, 70B, 70C, chaque rivet disposé une distance supérieure ou égale au seuil de distance de chaque tranche de ladite tôle 70A, 70B, 70C destinée à être soudée à une tranche d'une autre tôle 70A, 70B, 70C.

Lors de la deuxième étape d'assemblage 220, un deuxième ensemble de rivets est mis en place. Chaque rivet du deuxième ensemble est un rivet fixant l'une des tôles 70A, 70B, 70C à la charpente 50.

Chaque rivet du deuxième ensemble est disposé à une distance strictement inférieure au seuil de distance d'une soudure entre deux tôles 70A, 70B, 70C.

Le premier et le deuxième ensemble de rivets sont complémentaires. En d'autres termes, chaque rivet fixant une tôle 70A, 70B, 70C à la charpente 50 est un rivet du premier ensemble ou un rivet du deuxième ensemble.

Puisque chaque tôle 70A, 70B, 70C est soudées à au moins une autre tôle, le risque de fuites est limité puisque le nombre d'interfaces entre deux tôles 70A, 70B, 70C requérant un mastic susceptible de s'endommager avec le temps est limité. La durabilité du coffre 30 est donc améliorée.

En particulier, lorsque l'ensemble de tôles 70A, 70B, 70C est monobloc, le nombre de telles interfaces est particulièrement réduit et la durabilité est encore améliorée.

Une soudure bout à bout permet de réduire la quantité de matériau nécessaire à la fabrication de l'enveloppe tout en assurant une bonne étanchéité. En effet, aucun recouvrement entre les tôles 70A, 70B, 70C n'est alors nécessaire.

L'aluminium se prête bien au soudage et est donc particulièrement adapté à la confection d'un coffre 30 présentant une bonne durabilité.

La collerette 80 permet également d'améliorer l'étanchéité du coffre 30 puisqu'ainsi de l'eau qui s'écoulerait sur les tôles 70 ne peut atteindre le passage 85 entouré par la collerette 80.

Lorsque la collerette 80 comporte des portions courbes 100 rapportées et soudées à l'enveloppe 55, le risque de fuite est encore réduit. Par ailleurs, peu de matériau est nécessaire.

En outre, lorsque les portions rectilignes 95 sont venues de matière avec les tôles 70A, 70B, 70C, notamment lorsqu'elles sont obtenues par pliage de ces tôles 70A, 70B, 70C, la fabrication du coffre 30 est facilitée, et le risque de fuite est encore limité.

L'utilisation de deux étapes 200 et 220 d'assemblage de part et d'autre de l'étape de soudage permet d'assurer que le soudage n'aura pas d'effet négatif sur les rivets (ou autres fixations) déjà mis en place, puisqu'il est alors possible de ne mettre en place avant le soudage que les rivets qui ne seront pas endommagés par le soudage.

Pour cela, le choix de ne mettre en place avant le soudage que les rivets suffisamment éloignés des soudures, notamment éloignés de plus de 200 mm, permet d'éviter de générer trop de contraintes dans les rivets déjà mis en place lors de la soudure.

## Revendications

1. Coffre de toit (30) pour un véhicule (10) de transport en commun, le coffre (30) étant prévu pour être fixé sur le toit (38) du véhicule (10), le coffre (30) comportant une charpente (50) et une enveloppe (55) fixée à la charpente (50), la charpente (50) étant configurée pour supporter l'enveloppe (55), l'enveloppe (55) délimitant un volume interne (45) du coffre (30), l'enveloppe (55) comportant un ensemble de tôles métalliques (70A, 70B, 70C) séparant le volume interne (45) de l'extérieur du coffre (30),
le coffre (30) étant **caractérisé en ce que** chaque tôle métallique (70A, 70B, 70C ) est assemblée à la charpente (50) et soudée à au moins une autre tôle (70A, 70B, 70C),
dans lequel l'enveloppe (55) délimite au moins un passage (85) traversant l'enveloppe (55) selon une direction normale à l'enveloppe (55), le coffre (30) comportant, en outre, une collerette (80) et un panneau (75) configuré pour obturer le passage (85), le panneau (75) étant disposé en regard d'une face externe (90) de l'enveloppe (55), la collerette (80) entourant le passage (85) dans un plan perpendiculaire à la direction normale et s'étendant selon la direction normale depuis la face externe (90), la collerette (80) étant interposée entre le panneau (75) et l'enveloppe (55) lorsque le panneau (75) obture le passage (85), le panneau (75) étant notamment en appui contre un joint porté par la collerette (80) lorsque le panneau (75) obture le passage (85),
et dans lequel la collerette (80) comporte un ensemble de portions rectilignes (95) et un ensemble de portions courbes (100), chaque portion courbe (100) s'étendant selon une ligne courbe dans un plan perpendiculaire à la direction normale, chaque portion courbe (100) étant interposée entre deux portions rectilignes (95), chaque portion courbe (100) étant formée par une pièce rapportée soudée à au moins une des tôles (70A, 70B, 70C).

2. Coffre selon la revendication 1, dans lequel les tôles (70A, 70B, 70C) sont soudées les unes aux autres de manière à former un ensemble monobloc de tôles (70A, 70B, 70C).

3. Coffre selon la revendication 1 ou 2, dans lequel chaque portion rectiligne (95) est venue de matière avec l'une des tôles (70A, 70B, 70C), la portion rectiligne (95) étant notamment formée par pliage de ladite tôle (70A, 70B, 70C).

4. Véhicule de transport en commun (10) comportant un coffre (30) selon l'une quelconque des revendications précédentes.

5. Véhicule selon la revendication 4, le véhicule (10) étant un véhicule électrique comportant un moteur (15) et un pantographe (20), le moteur (15) étant configuré pour propulser le véhicule (10), le pantographe (20) étant configuré pour recevoir un premier courant électrique d'un caténaire (40) et pour transmettre le premier courant à au moins un dispositif (25) accueilli dans le volume interne (45) du coffre (30), le dispositif (25) étant configuré pour convertir le premier courant en un deuxième courant électrique différent du premier courant électrique et pour alimenter le moteur (15) avec le deuxième courant.

6. Procédé de fabrication d'un coffre de toit (30) pour un véhicule de transport en commun (10), le coffre (30) étant prévu pour être fixé sur un toit (38) du véhicule (10), le coffre (30) comportant une charpente (50) et une enveloppe (55) fixée à la charpente (50), la charpente (50) étant configurée pour supporter l'enveloppe (55), l'enveloppe (55) délimitant un volume interne (45) du coffre, l'enveloppe comportant un ensemble de tôles métalliques (70A, 70B, 70C) séparant le volume interne (45) de l'extérieur du coffre (30), dans lequel l'enveloppe (55) délimite au moins un passage (85) traversant l'enveloppe (55) selon une direction normale à l'enveloppe (55), le coffre (30) comportant, en outre, une collerette (80) et un panneau (75) configuré pour obturer le passage (85), le panneau (75) étant disposé en regard d'une face externe (90) de l'enveloppe (55), la collerette (80) entourant le passage (85) dans un plan perpendiculaire à la direction normale et s'étendant selon la direction normale depuis la face externe (90), la collerette (80) étant interposée entre le panneau (75) et l'enveloppe (55) lorsque le panneau (75) obture le passage (85), le panneau (75) étant notamment en appui contre un joint porté par la collerette (80) lorsque le panneau (75) obture le passage (85), et dans lequel la collerette (80) comporte un ensemble de portions rectilignes (95) et un ensemble de portions courbes (100), chaque portion courbe (100) s'étendant selon une ligne courbe dans un plan perpendiculaire à la direction normale, chaque portion courbe (100) étant interposée entre deux portions rectilignes (95), chaque portion courbe (100) étant formée par une pièce rapportée soudée à au moins une des tôles (70A, 70B, 70C),
le procédé étant **caractérisé en ce qu'**il comporte :
- une première étape (200) d'assemblage de chaque tôle (70A, 70B, 70C) à la charpente (50), et
- une étape (210) de soudage des tôles (70A, 70B, 70C) entre elles de manière à former une enveloppe (55) monobloc, l'étape de soudage (210) étant mise en œuvre postérieurement à la première étape d'assemblage (200).

7. Procédé selon la revendication 6, dans lequel la première étape d'assemblage (200) comporte l'assemblage de chaque tôle (70A, 70B, 70C) à la charpente (50) avec un premier ensemble de rivets, chaque rivet fixant une tôle (70A, 70B, 70C ) à la charpente (50), le procédé comportant, en outre, une deuxième étape (220) d'assemblage comportant le rivetage d'au moins une tôle (70A, 70B, 70C) à la charpente (50) avec un deuxième ensemble de rivets, le deuxième ensemble étant disjoint du premier ensemble, la deuxième étape d'assemblage (220) étant mise en œuvre postérieurement à l'étape de soudage (210).

8. Procédé selon la revendication 7, dans lequel un seuil de distance est défini pour l'enveloppe (55), chaque rivet du deuxième ensemble étant disposé à une distance inférieure audit seuil d'une soudure entre deux tôles (70A, 70B, 70C), aucun rivet du premier ensemble n'étant disposé à une distance inférieure audit seuil d'une soudure entre deux tôles (70A, 70B, 70C), le seuil de distance étant, notamment, égal à 200 millimètres.

## Patentansprüche

1. Dachkoffer (30) für ein Fahrzeug (10) für den öffentlichen Verkehr, wobei der Koffer (30) bereitgestellt ist, um auf dem Dach (38) des Fahrzeugs (10) befestigt zu werden, der Koffer (30) umfassend ein Gerüst (50) und eine an dem Gerüst (50) befestigte Hülle (55), wobei das Gerüst (50) konfiguriert ist, um die Hülle (55) zu tragen, wobei die Hülle (55) ein Innenvolumen (45) des Koffers (30) begrenzt, die Hülle (55) umfassend eine Gruppe von Metallblechen (70A, 70B, 70C), die das Innenvolumen (45) von der Außenseite des Kofferraums (30) trennt,
wobei der Koffer (30) **dadurch gekennzeichnet ist, dass** jedes Metallblech (70A, 70B, 70C) mit dem Gerüst (50) zusammengebaut und mit mindestens einem anderen Blech (70A, 70B, 70C) verschweißt ist,
wobei die Hülle (55) mindestens einen Durchgang (85) begrenzt, der die Hülle (55) in einer senkrechten Richtung zu der Hülle (55) durchquert, wobei der Koffer (30) ferner einen Bund (80) und eine Platte (75) umfasst, die konfiguriert ist, um den Durchgang (85) zu verschließen, wobei die Platte (75) gegenüber einer Außenfläche (90) der Hülle (55) angeordnet ist, der Bund (80) den Durchgang (85) in einer Ebene senkrecht zu der senkrechten Richtung umgibt und sich in senkrechter Richtung von der Außenseite (90) erstreckt, wobei der Bund (80) zwischen der Platte (75) und der Hülle (55) eingefügt ist, wenn die Platte (75) den Durchgang (85) verschließt, wobei die Platte (75) insbesondere an einer von dem Bund (80) getragenen Dichtung anliegt, wenn die Platte (75) den Durchgang (85) verschließt,
und wobei der Bund (80) eine Gruppe von geraden Abschnitten (95) und eine Gruppe von gekrümmten Abschnitten (100) umfasst, wobei sich jeder gekrümmte Abschnitt (100) entlang einer gekrümmten Linie in einer Ebene senkrecht zu der senkrechten Richtung erstreckt, wobei jeder gekrümmte Abschnitt (100) zwischen zwei geraden Abschnitten (95) angeordnet ist, wobei jeder gekrümmte Abschnitt (100) durch einen Einsatz gebildet ist, der an mindestens eines der Bleche (70A, 70B, 70C) geschweißt ist.

2. Koffer nach Anspruch 1, wobei die Bleche (70A, 70B, 70C) miteinander verschweißt sind, sodass sie eine einteilige Einheit von Blechen (70A, 70B, 70C) bilden.

3. Koffer nach Anspruch 1 oder 2, wobei jeder gerade Abschnitt (95) aus einem der Bleche (70A, 70B, 70C) einstückig ist, wobei der gerade Abschnitt (95) insbesondere durch Biegen des Blechs (70A, 70B, 70C) gebildet wird.

4. Öffentliches Transportfahrzeug (10), umfassend einen Koffer (30) nach einem der vorherigen Ansprüche.

5. Fahrzeug nach Anspruch 4, wobei das Fahrzeug (10) ein Elektrofahrzeug ist, umfassend einen Motor (15) und einen Stromabnehmer (20), wobei der Motor (15) zum Antreiben des Fahrzeugs (10) konfiguriert ist, wobei der Stromabnehmer (20) konfiguriert ist, um einen ersten elektrischen Strom von einer Oberleitung (40) zu empfangen und den ersten Strom an mindestens eine Vorrichtung (25) zu übertragen, die im Innenvolumen (45) des Koffers (30) untergebracht ist, wobei die Vorrichtung (25) konfiguriert ist, um den ersten Strom in einen zweiten elektrischen Strom umzuwandeln, der sich von dem ersten elektrischen Strom unterscheidet, und um den Motor (15) mit dem zweiten Strom zu versorgen.

6. Verfahren zur Herstellung eines Dachkoffers (30) für ein öffentliches Transportfahrzeug (10), wobei der Kasten (30) bereitgestellt ist, um auf einem Dach (38) des Fahrzeugs (10) befestigt zu werden, wobei der Koffer (30) ein Gerüst (50) und eine an dem Gerüst (50) befestigte Hülle (55) umfasst, wobei das Gerüst (50) konfiguriert ist, um die Hülle (55) zu tragen, wobei die Hülle (55) ein Innenvolumen (45) des Koffers begrenzt, die Hülle umfassend eine Gruppe von Metallblechen (70A, 70B, 70C), die das Innenvolumen (45) von der Außenseite des Kofferraums (30) trennt, wobei die Hülle (55) mindestens einen Durchgang (85) begrenzt, der die Hülle (55) in einer senkrechten Richtung zu der Hülle (55) durchquert, wobei der Koffer (30) ferner einen Bund (80) und eine Platte (75) umfasst, die konfiguriert ist, um den Durchgang (85) zu verschließen, wobei die Platte (75) gegenüber einer Außenfläche (90) der Hülle (55) angeordnet ist, der Bund (80) den Durchgang (85) in einer Ebene senkrecht zu der senkrechten Richtung umgibt und sich in senkrechter Richtung von der Außenseite (90) erstreckt, wobei der Bund (80) zwischen der Platte (75) und der Hülle (55) eingefügt ist, wenn die Platte (75) den Durchgang (85) verschließt, wobei die Platte (75) insbesondere an einer von dem Bund (80) getragenen Dichtung anliegt, wenn die Platte (75) den Durchgang (85) verschließt, und wobei der Bund (80) eine Gruppe von geraden Abschnitten (95) und eine Gruppe von gekrümmten Abschnitten (100) umfasst, wobei sich jeder gekrümmte Abschnitt (100) entlang einer gekrümmten Linie in einer Ebene senkrecht zu der senkrechten Richtung erstreckt, wobei jeder gekrümmte Abschnitt (100) zwischen zwei geraden Abschnitten (95) angeordnet ist, wobei jeder gekrümmte Abschnitt (100) durch einen Einsatz gebildet ist, der an mindestens eines der Bleche (70A, 70B, 70C) geschweißt ist,
wobei das Verfahren **dadurch gekennzeichnet ist, dass** es Folgendes umfasst:
- einen ersten Schritt (200) eines Montierens von jedem Blech (70A, 70B, 70C) an dem Gerüst (50), und
- einen Schritt (210) zum Verschweißen der Bleche (70A, 70B, 70C) miteinander, um eine einteilige Hülle (55) zu bilden, wobei der Schritt des Verschweißens (210) nach dem ersten Montageschritt (200) durchgeführt wird.

7. Verfahren nach Anspruch 6, wobei dem der erste Montageschritt (200) das Verbinden von jedem Blech (70A, 70B, 70C) mit dem Gerüst (50) mit einem ersten Satz von Nieten umfasst, wobei jeder Niet ein Blech (70A, 70B, 70C) an dem Gerüst (50) befestigt, das Verfahren ferner umfassend einen zweiten Montageschritt (220), der das Vernieten mindestens eines Blechs (70A, 70B, 70C) an das Gerüst (50) mit einer zweiten Gruppe von Nieten umfasst, wobei die zweite Gruppe von der ersten Gruppe getrennt ist, wobei der zweite Montageschritt (220) nach dem Schweißschritt (210) durchgeführt wird.

8. Verfahren nach Anspruch 7, wobei eine Abstandsschwelle für die Hülle (55) definiert wird, wobei jeder Niet der zweiten Gruppe in einem Abstand angeordnet ist, der kleiner ist als die Schwelle einer Schweißnaht zwischen zwei Blechen (70A, 70B, 70C), wobei kein Niet der ersten Gruppe in einem Abstand angeordnet ist, der kleiner ist als die Schwelle einer Schweißnaht zwischen zwei Blechen (70A, 70B, 70C), wobei die Abstandsschwelle insbesondere gleich 200 Millimeter ist.

## Claims

1. A roof box (30) for a public transport vehicle (10), the box (30) being adapted to be secured to the roof (38) of the vehicle (10), the box (30) comprising a framework (50) and a shell (55) secured to the framework (50), the framework (50) being configured to support the casing (55), the casing (55) delimiting an internal volume (45) of the boot (30), the casing (55) comprising a set of metal sheets (70A, 70B, 70C) separating the internal volume (45) from the exterior of the box (30),
the box (30) being **characterised in that** each metal sheet (70A, 70B, 70C) is assembled to the framework (50) and welded to at least one other sheet (70A, 70B, 70C),
wherein the envelope (55) delimits at least one passage (85) passing through the envelope (55) in a direction normal to the envelope (55), the box (30) further comprising a flange (80) and a panel (75) configured to close off the passage (85), the panel (75) being disposed opposite an external face (90) of the envelope (55), the flange (80) surrounding the passage (85) in a plane perpendicular to the normal direction and extending in the normal direction from the external face (90), the flange (80) being interposed between the panel (75) and the envelope (55) when the panel (75) closes off the passage (85), the panel (75) being in particular in abutment against a seal carried by the flange (80) when the panel (75) closes off the passage (85),
and wherein the flange (80) comprises a set of straight portions (95) and a set of curved portions (100), each curved portion (100) extending along a curved line in a plane perpendicular to the normal direction, each curved portion (100) being interposed between two straight portions (95), each curved portion (100) being formed by an insert welded to at least one of the sheets (70A, 70B, 70C).

2. A case according to claim 1, wherein the sheets (70A, 70B, 70C) are welded together so as to form a one-piece assembly of sheets (70A, 70B, 70C).

3. A case according to claim 1 or 2, wherein each rectilinear portion (95) is integral with one of the sheets (70A, 70B, 70C), the rectilinear portion (95) being formed in particular by bending said sheet (70A, 70B, 70C).

4. Public transport vehicle (10) comprising a box (30) according to any one of the preceding claims.

5. A vehicle according to claim 4, the vehicle (10) being an electric vehicle comprising a motor (15) and a pantograph (20), the motor (15) being configured to propel the vehicle (10), the pantograph (20) being configured to receive a first electrical current from a catenary (40) and to transmit the first current to at least one device (25) housed within the internal volume (45) of the trunk (30), the device (25) being configured to convert the first current into a second electrical current different from the first electrical current and to supply the motor (15) with the second current.

6. A method of manufacturing a roof box (30) for a public transport vehicle (10), the box (30) being intended to be fixed to a roof (38) of the vehicle (10), the box (30) comprising a framework (50) and a casing (55) fixed to the framework (50), the framework (50) being configured to support the casing (55), the casing (55) delimiting an internal volume (45) of the boot, the casing comprising a set of metal sheets (70A, 70B, 70C) separating the internal volume (45) from the exterior of the box (30)
wherein the envelope (55) delimits at least one passage (85) passing through the envelope (55) in a direction normal to the envelope (55), the box (30) further comprising a flange (80) and a panel (75) configured to close off the passage (85), the panel (75) being disposed opposite an external face (90) of the envelope (55), the flange (80) surrounding the passage (85) in a plane perpendicular to the normal direction and extending in the normal direction from the external face (90), the flange (80) being interposed between the panel (75) and the envelope (55) when the panel (75) closes off the passage (85), the panel (75) being in particular in abutment against a seal carried by the flange (80) when the panel (75) closes off the passage (85), and wherein the flange (80) comprises a set of straight portions (95) and a set of curved portions (100), each curved portion (100) extending along a curved line in a plane perpendicular to the normal direction, each curved portion (100) being interposed between two straight portions (95), each curved portion (100) being formed by an insert welded to at least one of the sheets (70A, 70B, 70C).
the method being **characterised in that** it comprises:
- a first step (200) of assembling each sheet (70A, 70B, 70C) to the framework (50), and
- a step (210) of welding the sheets (70A, 70B, 70C) together so as to form a one-piece envelope (55), the welding step (210) being implemented after the first assembly step (200).

7. A method according to claim 6, wherein the first assembly step (200) comprises assembling each sheet (70A, 70B, 70C) to the framework (50) with a first set of rivets, each rivet securing a sheet (70A, 70B, 70C) to the framework (50), the method further comprising a second assembly step (220) comprising the riveting of at least one sheet (70A, 70B, 70C) to the framework (50) with a second set of rivets, the second set being separated from the first set, the second assembly step (220) being implemented after the welding step (210).

8. A method according to claim 7, wherein a distance threshold is defined for the envelope (55), each rivet of the second set being disposed at a distance less than said threshold of a weld between two sheets (70A, 70B, 70C), no rivet of the first set being disposed at a distance less than said threshold of a weld between two sheets (70A, 70B, 70C), the distance threshold being, in particular, equal to 200 mm.
